# EUROPEAN PATENT APPLICATION

(11) **EP 4 435 545 A1**
(43) Date of publication of application: **25.09.2024**
(21) Application number: 24161965.9
(22) Date of filing: 07.03.2024
(51) Int. Cl.: G05B 23/02, H01L 21/67

(54) **CONTROL APPARATUS, SUBSTRATE PROCESSING APPARATUS, METHOD OF MANUFACTURING SEMICONDUCTOR DEVICE, AND PROGRAM**

(30) Priority: 24.03.2023 JP 2023048169
(71) Applicant: Kokusai Electric Corporation, Tokyo 101-0045 (JP)
(72) Inventor: MITSUI, Hiroyuki, Toyama-shi, Toyama 939-2393 (JP); MORI, Shinichiro, Toyama-shi, Toyama 939-2393 (JP)
(74) Representative: Bardehle Pagenberg Partnerschaft mbB Patentanwälte Rechtsanwälte

(57) **Abstract**

There is provided a technique including a memory (104) that stores an event item indicating at least one event related to a target apparatus (1), and a controller (101) that is capable of controlling notifying a display (204) of an event item corresponding to an occurred event when the event item corresponding to the occurred event is stored in the memory (104).

## Description

### CROSS-REFERENCE TO RELATED APPLICATION

This application is based upon and claims the benefit of priority from Japanese Patent Application No. 2023-048169, filed on March 24, 2023, the entire contents of which are incorporated herein by reference.

### TECHNICAL FIELD

The present disclosure relates to a control apparatus, a substrate processing apparatus, a method of manufacturing a semiconductor device, and a program.

### BACKGROUND

In a substrate processing apparatus, when any event occurs during substrate processing, a person in charge of operation may first investigate a cause, and then perform a recovery operation while considering the cause. For example, the related art discloses a technique that, when an alarm occurs, enables recovery of the alarm by displaying a recovery procedure for each alarm on an operation screen based on a type of the alarm.

In the technique described in the related art, when an alarm related to a system error occurs, a recovery procedure for the alarm is displayed on the operation screen. However, there are various events related to a target apparatus such as a substrate processing apparatus, and a response to the various events is not introduced.

### SUMMARY

Some embodiments of the present disclosure provide a technique capable of facilitating a recovery operation for various events, thereby shortening a down time of a target apparatus.

According to embodiments of the present disclosure, there is provided a technique that includes a memory that stores an event item indicating at least one event related to a target apparatus, and a controller that is capable of controlling notifying a display of an event item corresponding to an occurred event when the event item corresponding to the occurred event is stored in the memory.

### BRIEF DESCRIPTION OF DRAWINGS

The accompanying drawings, which are incorporated in and constitute a part of the specification, illustrate embodiments of the present disclosure.
FIG. 1 is a perspective view illustrating an example of a substrate processing apparatus according to the embodiments.
FIG. 2 is a cross-sectional view of the substrate processing apparatus according to the embodiments when viewed from a side.
FIG. 3 is a block diagram illustrating an example of a functional configuration of a control apparatus included in the substrate processing apparatus according to the embodiments.
FIG. 4 is a front view illustrating an example of an information display screen according to the embodiments.
FIG. 5A is a front view illustrating an example of an event item display screen according to the embodiments.
FIG. 5B is a front view illustrating another example of the event item display screen according to the embodiments.
FIG. 6 is a diagram illustrating an example of an event item according to the embodiments.
FIG. 7 is a diagram illustrating an example of an event display button according to the embodiments.
FIG. 8 is a front view illustrating an example of an event response screen according to the embodiments.
FIG. 9 is a diagram illustrating an example of event item display information according to the embodiments.
FIG. 10 is a flowchart illustrating an example of a flow of an event occurrence notification process according to the embodiments.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

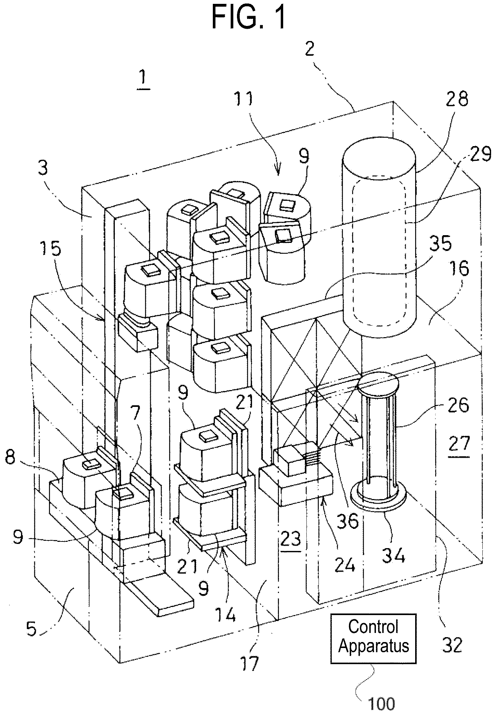

Hereinafter, embodiments of the present disclosure will be described mainly with reference to FIGS. 1 to 10. In addition, the drawings used in the following descriptions are all schematic, and a relationship between the dimensions of respective elements, the ratios of respective elements, and the like illustrated in the drawings do not necessarily correspond to the reality. Further, a relationship between the dimensions of respective elements, the ratios of respective elements, etc. may not necessarily correspond between multiple drawings. Further, the present disclosure is not limited to the following embodiments in any way, and modifications may be made within the scope of the present disclosure as appropriate.

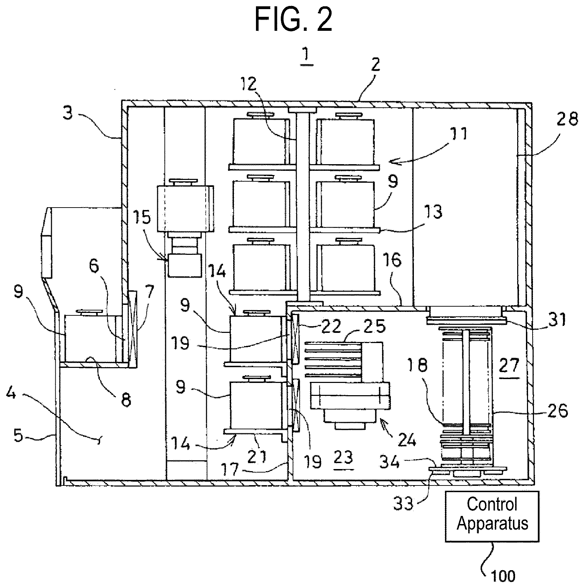

First, an outline of a substrate processing apparatus according to the embodiments of the present disclosure will be described with reference to FIGS. 1 and 2.

FIG. 1 is a perspective view illustrating an example of a substrate processing apparatus 1 according to the embodiments of the present disclosure. Further, FIG. 2 is a cross-sectional view of the substrate processing apparatus 1 according to the embodiments of the present disclosure when viewed from the side. FIGS. 1 and 2 illustrate the vertical substrate processing apparatus 1 as an example of the substrate processing apparatus. In addition, a substrate that is processed in the substrate processing apparatus 1 is illustrated as an example of a semiconductor wafer made of silicon or the like.

As illustrated in FIGS. 1 and 2, the substrate processing apparatus 1 includes a housing 2, and a front maintenance port 4, as an opening configured to allow maintenance, is formed at a lower portion of a front wall 3 of the housing 2. The front maintenance port 4 is opened and closed by a front maintenance door 5.

A pod loading/unloading port 6 is formed in the front wall 3 of the housing 2 to bring an inside and an outside of the housing 2 into fluid communication with each other. The pod loading/unloading port 6 is opened and closed by a front shutter 7, which is a loading/unloading port opening/closing mechanism. A load port 8, which is a substrate transfer container delivery stand, is installed at a front side of the pod loading/unloading port 6. The load port 8 is configured to align a pod 9 loaded thereon.

The pod 9 is a sealed substrate transfer container, and is loaded onto and unloaded from the load port 8 by an in-process transfer apparatus (not illustrated).

A rotary pod shelf 11, which is a substrate transfer container storage shelf, is installed at an upper region inside the housing 2 at the approximately center in the front-to-back direction. The rotary pod shelf 11 is configured to store a plurality of pods 9.

The rotary pod shelf 11 includes a pillar 12, which is vertically erected and intermittently rotates, and shelf plates 13, which are multi-stage substrate transfer container mounting shelves, supported radially by the pillar 12 at upper, middle, and lower positions, respectively. Each of the shelf plates 13 is configured to store at least one pod 9 loaded thereon.

A pod opener 14, which is a substrate transfer container lid opening/closing mechanism, is provided below the rotary pod shelf 11. The pod opener 14 is configured to be capable of mounting the pod 9 thereon and opening and closing the lid of the pod 9.

A pod transfer mechanism 15, which is a container transfer mechanism, is installed among the load port 8, the rotary pod shelf 11, and the pod opener 14. The pod transfer mechanism 15 is configured to be capable of vertically moving and horizontally being retracted while holding the pod 9. The pod transfer mechanism 15 is configured to transfer the pod 9 among the load port 8, the rotary pod shelf 11, and the pod opener 14.

A sub-housing 16 is provided at a lower portion approximately at a center in the front-to-back direction in the housing 2 so as to extend over the rear end. A pair of wafer loading/unloading ports 19, which are substrate loading/unloading ports for loading and unloading a wafer 18, which is a substrate, into and out of the sub-housing 16, are formed at a front wall 17 of the sub-housing 16 and are vertically arranged at two stages of an upper stage and a lower stage. The pod opener 14 is installed for each of upper and lower wafer loading/unloading ports 19.

The pod opener 14 includes a mounting stand 21 on which the pod 9 is mounted and an opening/closing mechanism 22 for opening and closing the lid of the pod 9. The pod opener 14 is configured to open and close a wafer entrance of the pod 9 by opening and closing the lid of the pod 9 mounted on the mounting stand 21 using the opening/closing mechanism 22.

The sub-housing 16 constitutes a transfer chamber 23, which is kept airtight from a space (pod transfer space) where the pod transfer mechanism 15 and the rotary pod shelf 11 are arranged. A wafer transfer mechanism 24, which is a substrate transfer mechanism, is installed in a front region of the transfer chamber 23. The wafer transfer mechanism 24 includes a pluarlity (e.g., five in the illustration) of wafer mounting plates 25 for mounting the wafer 18 thereon. The wafer mounting plates 25 are configured to be movable linearly in the horizontal direction, to be rotatable in the horizontal direction, or to be movable vertically. The wafer transfer mechanism 24 is configured to charge and discharge the wafer 18 into and out of a boat 26, which is a substrate holder.

A standby part 27 configured to accommodate and keep the boat 26 in a standby state is formed in a rear region of the transfer chamber 23, and a vertical process furnace 28 is provided above the standby part 27. A process chamber 29 is formed inside the process furnace 28, and a lower end of the process chamber 29 is formed as a furnace opening. The furnace opening is configured to be opened and closed by a furnace opening shutter 31, which is a furnace opening/closing mechanism. In addition, the process chamber 29 is an example of a process container.

A boat elevator 32, which is a substrate holder elevator, configured to raise or lower the boat 26 is installed between a right end of the housing 2 and a right end of the standby part 27 of the sub-housing 16. A seal cap 34, which serves as a lid, is installed horizontally to an arm 33 connected to an elevating stand of the boat elevator 32. The seal cap 34 is configured to vertically support the boat 26 and to airtightly close the furnace opening when the boat 26 is charged into the process chamber 29.

The boat 26 is configured to hold a plurality of (e.g., about 50 to 125) wafers 18 in such a state that the wafers are arranged in a horizontal posture and in multiple stages with centers of the wafers aligned with one another. In addition, in the present disclosure, a notation of a numerical range such as "50 to 125" means that a lower limit value and an upper limit value are included in that range. Thus, for example, "50 to 125" means "50 wafers or more and 125 wafers or less." The same is applied to other numerical ranges.

A cleaner 35 is arranged at a position facing the boat elevator 32. The cleaner 35 is composed of a supply fan and a dust filter to supply clean air 36, which is a purified atmosphere or inert gas. For example, a nitrogen (N)-containing gas may be used as the inert gas. As the N-containing gas, for example, a nitrogen (N₂) gas, ammonia (NH₃) gas or the like may be used. One or more of these may be used as the N-containing gas. A notch aligner (not illustrated), which serves as a substrate aligner for aligning locations of the wafer 18 in a circumferential direction thereof, is installed between the wafer transfer mechanism 24 and the cleaner 35.

The clean air 36 blown out from the cleaner 35 circulates through the notch aligner (not illustrated), the wafer transfer mechanism 24, and the boat 26, and is then sucked into a duct (not illustrated), and is discharged to the outside of the housing 2 or blown into the transfer chamber 23 by the cleaner 35.

Next, an operation of the substrate processing apparatus 1 will be described.

When the pod 9 is supplied to the load port 8, the pod loading/unloading port 6 is opened by the front shutter 7. The pod 9 on the load port 8 is loaded to the interior of the housing 2 through the pod loading/unloading port 6 by the pod transfer mechanism 15, and is mounted on the designated shelf plate 13 of the rotary pod shelf 11. After being temporarily stored on the rotary pod shelf 11, the pod 9 is transferred from the shelf plate 13 to one of the pod openers 14 and is transferred to the mounting stand 21 or transferred directly from the load port 8 to the mounting stand 21 by the pod transfer mechanism 15.

At this time, each wafer loading/unloading port 19 is closed by the opening/closing mechanism 22, and the transfer chamber 23 is filled with the circulated clean air 36 flowing therethrough. For example, the transfer chamber 23 is filled with the N-containing gas as the clean air 36, so that a concentration of oxygen is set to, for example, 20 ppm or less, which is lower than a concentration of oxygen in the interior (atmospheric atmosphere) of the housing 2.

An end surface at an opening side of the pod 9 mounted on the mounting stand 21 is pressed against an opening edge of the wafer loading/unloading port 19 in the front wall 17 of the sub-housing 16, and the lid of the pod 9 is removed by the opening/closing mechanism 22 to open the wafer entrance.

When the pod 9 is opened by the pod opener 14, the wafer 18 is discharged from the pod 9 by the wafer transfer mechanism 24, and is then transferred to the notch aligner (not illustrated). After the wafer 18 is aligned by the notch aligner, the wafer transfer mechanism 24 loads the wafer 18 to the standby part 27 located at a rear region of the transfer chamber 23 and charges the wafer 18 into the boat 26.

After delivering the wafer 18 to the boat 26, the wafer transfer mechanism 24 returns to the pod 9 and charges the next wafer 18 into the boat 26.

While the wafer transfer mechanism 24 is charging the wafer 18 from one (upper or lower) pod opener 14 into the boat 26, another pod 9 is transferred from the rotary pod shelf 11 to the other (lower or upper) pod opener 14 by the pod transfer mechanism 15. Simultaneously, the pod 9 is opened by the pod opener 14 at the other side.

When a predetermined number of wafers 18 are charged into the boat 26, the furnace opening of the process furnace 28, which was closed by the furnace opening shutter 31, is opened by the furnace opening shutter 31. Subsequently, the boat 26 is raised by the boat elevator 32 and is loaded into the process chamber 29.

After loading, the furnace opening is airtightly closed by the seal cap 34. In addition, in the embodiments of the present disclosure, at this timing (after loading), a purge step (pre-purge step) is performed in which the atmosphere inside the process chamber 29 is replaced with an inert gas.

The process chamber 29 is vacuum-exhausted by a gas exhaust mechanism (not illustrated) to reach a desired pressure (vacuum degree). Further, the process chamber 29 is heated to a predetermined temperature by a heater driver (not illustrated) to achieve desired temperature distribution.

Further, a process gas controlled at a predetermined flow rate is supplied by a gas supplier (not illustrated). In process of flowing through the process chamber, the process gas comes into contact with a surface of the wafer 18, and a predetermined process is performed on the surface of the wafer 18. Furthermore, the process gas after the reaction is discharged from the process chamber 29 by the gas exhaust mechanism. The term "process gas" herein refers to a gas supplied into the process chamber 29. The same applies to the following description.

After a preset process time has passed, an inert gas is supplied from an inert gas source (not illustrated) by the gas supplier, so that the process chamber 29 is replaced with the inert gas, and the pressure in the process chamber 29 returns to normal pressure (after-purge step). Then, the boat 26 is lowered by the boat elevator 32 via the seal cap 34. The term "process time" herein refers to a time during which the process is continued. The same applies to the following description.

For the unloading of the processed wafer 18, the wafer 18 and the pod 9 are unloaded to the outside of the housing 2 in the reverse procedure of the above-described procedure. Unprocessed wafers 18 are also charged into boat 26, and a batch process of the wafers 18 is repeated.

Here, as illustrated in FIGS. 1 and 2, the substrate processing apparatus 1 includes a control apparatus 100, and the control apparatus 100 controls the substrate processing apparatus 1. The control apparatus 100 may be built into the substrate processing apparatus 1, or may be provided in an accessible manner outside the substrate processing apparatus 1. The substrate processing apparatus 1 is an example of a target apparatus. In the following, a case where the control apparatus 100 according to the embodiments of the present disclosure is applied to the substrate processing apparatus 1 will be described, but the control apparatus 100 may control apparatuses other than the substrate processing apparatus 1.

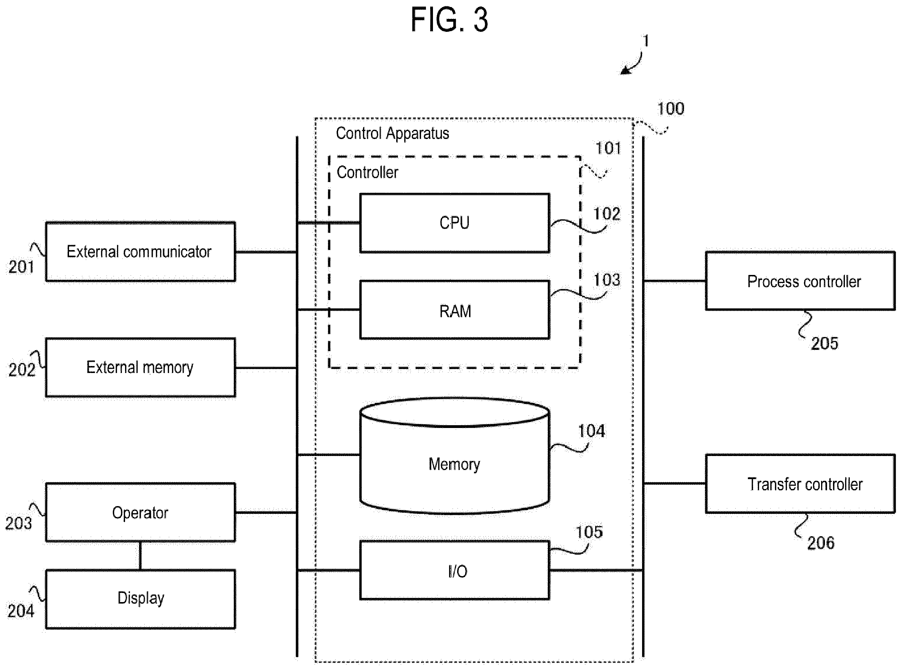

Next, a configuration of a control system of the substrate processing apparatus 1 according to the embodiments of the present disclosure will be described with reference to FIG. 3.

FIG. 3 is a block diagram illustrating an example of a functional configuration of the control apparatus 100 included in the substrate processing apparatus 1 according to the embodiments of the present disclosure.

As illustrated in FIG. 3, the substrate processing apparatus 1 includes the control apparatus 100 as a main controller, an external communicator 201, an external memory 202, an operator 203, a display 204, a process controller 205, and a transfer controller 206.

Further, the control apparatus 100 includes a controller 101, a memory 104, and an I/O (also referred to as "I/O port") 105. The controller 101 includes a central processing unit (CPU) 102 and a random access memory (RAM) 103.

The control apparatus 100 is connected to the operator 203 and is also connected to the process controller 205 and the transfer controller 206 via the I/O 105. Since the control apparatus 100 is electrically connected to each of the process controller 205 and the transfer controller 206 via the I/O 105, it is configured to be capable of transmitting and receiving respective data or uploading and downloading respective files.

The control apparatus 100 is connected to an external host computer (not illustrated) via the external communicator 201. Therefore, even in a case where the substrate processing apparatus 1 is installed in a clean room, it is possible to install the host computer in an office outside the clean room. Further, the control apparatus 100 is connected to the external memory 202, which serves as a mount into which a universal serial bus (USB) memory, as an example of a recording medium, is removably inserted.

The operator 203 is integrated with the display 204, or is connected to the display 204 via, for example, a video cable. The display 204 is, for example, a liquid crystal display panel. The display 204 is configured to display each operation screen for operating the substrate processing apparatus 1. The operation screen includes a screen for monitoring a status of a substrate process system controlled by the process controller 205 and a substrate transfer system controlled by the transfer controller 206. The display 204 may be provided with each operation button as an input unit to input operational instructions of the substrate process system and the substrate transfer system. The operator 203 causes the display 204 to display information generated in the substrate processing apparatus 1 through the operation screen. Further, the operator 203 causes information displayed on the display 204 to be outputted to a device such as a USB memory inserted into the external memory 202. The operator 203 receives input data (input instructions) from the operation screen displayed on the display 204, and transmits the input data to the control apparatus 100. Further, the operator 203 receives instructions (control instructions) to execute an arbitrary substrate process recipe (also referred to as a "process recipe") among a plurality of recipes developed in the RAM 103 or stored in the memory 104, and transmits the instructions to the control apparatus 100. In addition, the operator 203 and the display 204 may be configured with a touch panel. Here, the operator 203 and the display 204 are provided separately from the control apparatus 100 in the illustrated example, but may be integrally included in the control apparatus 100.

The process controller 205, although not illustrated here, includes a temperature controller, a gas flow-rate controller, and a pressure controller. Each of the temperature controller, the gas flow-rate controller, and the pressure controller constitutes a sub-controller and is electrically connected to the process controller 205, so that it is configured to be capable of transmitting and receiving various data, downloading and uploading various files, and the like. In addition, the process controller 205 and each sub-controller (temperature controller, gas flow-rate controller, and pressure controller) are configured separately, but may be integrally configured.

The transfer controller 206, although not illustrated here, includes a mechanism controller. This mechanism controller is configured to control each of a driver system, a rotator system, and an elevator system of the substrate processing apparatus 1. The transfer controller 206 is configured to control, for example, a transfer operation of each of the rotary pod shelf 11, boat elevator 32, pod transfer mechanism 15, wafer transfer mechanism 24, boat 26, and rotation mechanism (not illustrated).

In addition, the control apparatus 100, process controller 205, and transfer controller 206 according to the embodiments of the present disclosure are not limited to a dedicated system and may be realized using a conventional computer system. For example, each controller that executes a predetermined process may be configured by installing a program for executing the above-described process from a recording medium (such as CD-ROM or USB) storing that program to a general-purpose computer.

Then, there is an arbitrary way for supplying the program. The program may be supplied via a predetermined recording medium as described above, or alternatively, may be supplied to the memory 104 via, for example, communication lines, communication networks, communication systems, etc.

The control apparatus 100 is constituted as a computer including the CPU 102, RAM 103, memory 104, and I/O 105. The memory 104 stores recipe files such as recipes in which process conditions and process procedures are defined, a control program file for executing each recipe file, a parameter file (setting value file) for setting the process conditions and process procedures, an error-processing program file, an error-processing parameter file, a file of various screens including an input screen for inputting process parameters, a file of various icons, etc. (none of which are illustrated). In addition, the control apparatus 100 is connected to a network such as the Internet, local area network (LAN), or wide area network (WAN) using the external communicator 201, and is capable of communicating with external devices via the network.

Further, for example, a hard disk drive (HDD), solid state drive (SSD), flash memory, etc. are used as the memory 104. The memory 104 stores an event occurrence notification processing program for executing an event occurrence notification process according to the embodiments of the present disclosure.

The event occurrence notification processing program may be installed in advance in the substrate processing apparatus 1, for example. The event occurrence notification processing program may be realized by being recorded on a non-volatile recording medium, or distributed via a network, and appropriately installed in the substrate processing apparatus 1. In addition, examples of the non-volatile recording medium may include a CD-ROM, magneto-optical disk, HDD, DVD-ROM, flash memory, memory card, USB, and the like.

In other words, the event occurrence notification processing program is a program that causes a computer to execute a process including: storing at least one event item indicating an event related to the substrate processing apparatus 1, which is an example of a target apparatus, in the memory 104; notifying the display 204 of an event item corresponding to an occurred event when the event item corresponding to the occurred event is stored in the memory 104; displaying the notified event item on the display 204; and controlling the processing of a substrate (e.g., wafer 18) based on an occurrence status of the event.

The CPU 102 of the substrate processing apparatus 1 according to the embodiments of the present disclosure functions as the controller 101 by writing the event occurrence notification processing program stored in the memory 104 into the RAM 103 and executing the event occurrence notification processing program.

The substrate processing apparatus 1 according to the embodiments of the present disclosure includes the controller 101, the memory 104, and the display 204.

The memory 104 stores at least one event item indicating an event related to the substrate processing apparatus 1. In the case of the substrate processing apparatus 1, the event item includes, for example, at least one selected from the group of a recovery standby of an alarm occurred in a self-operating apparatus, a condition standby for executing a recipe, a recovery standby due to substrate crack detection, a condition standby for continuing substrate processing including a recipe, and installation standby of an update program.

That is, as the event item, at least one of the following items is stored in the memory 104. Addition, deletion, modification and the like are possible for event items stored in the memory 104.
(1) Alarm recovery standby
(2) Recipe execution condition standby
(3) Substrate crack detection recovery standby
(4) Condition standby for continuing substrate processing including a recipe
(5) Installation standby of an update program

There may be a case where event items may be different according to a type of apparatus and conditions. Thus, by storing various event items in the memory 104, it is possible to cope with various apparatus-specific event items.

When an event item corresponding to an occurred event is stored in the memory 104, it is possible for the controller 101 to perform a control of notifying the display 204 of the event item corresponding to the occurred event.

Specifically, an event item, which is a display target, is stored in advance in the memory 104, as described above. The event item is not limited to being stored in the memory 104, but may be acquired by accessing an external recording medium such as a USB memory, CD, or DVD via the external memory 202. Further, the event item may be acquired by accessing an external device via the external communicator 201. When an event item corresponding to an event notified from the process controller 205 or the transfer controller 206 via the I/O 105 matches the event item stored in the memory 104, the controller 101 notifies the display 204 of the event item corresponding to that event, and in other words, notifies of event occurrence.

The display 204 collectively displays a plurality of events that occur in the substrate processing apparatus 1 upon receiving a notification from the controller 101. In addition, one event may be displayed. This makes it easy to confirm the events occurring in the substrate processing apparatus 1.

Further, it is possible for the controller 101 to control substrate processing based on an occurrence status of an event. For example, the controller 101 may control whether to continue substrate processing based on an event item indicating an event that is occurring.

The processing of a substrate is performed, for example, based on a recipe that defines process conditions for the substrate. The recipe is stored in the memory 104, and the controller 101 acquires the stored recipe during the substrate processing and controls the substrate processing based on the process conditions defined in the recipe. The recipe may be not only stored in the memory 104, but also read from a USB memory, CD, or DVD via the external memory 202. Further, the recipe may be acquired from an external device via the external communicator 201.

By controlling whether to continue the substrate processing based on the event item that is occurring, it becomes possible to reduce standby time for events unrelated to the substrate processing. Further, when an event that affects the substrate processing occurs, the processing of the substrate is stopped and a control for waiting for event recovery is performed, so that it is possible to suppress generation of defective substrates.

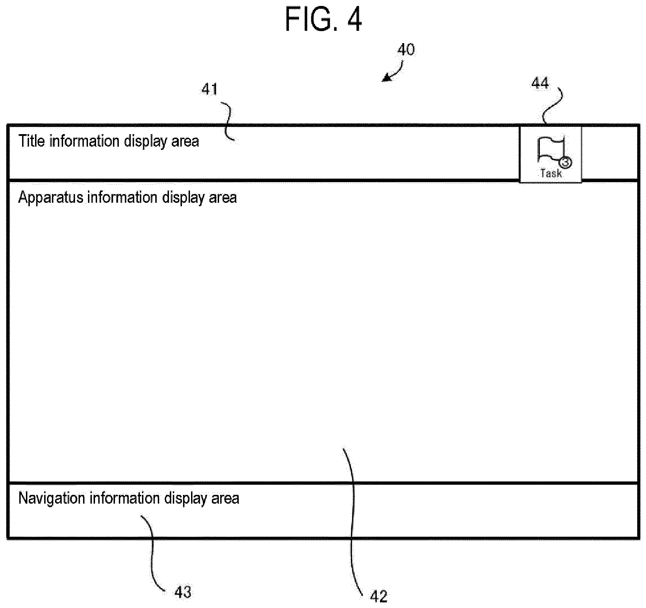

FIG. 4 is a front view illustrating an example of an information display screen 40 according to the embodiments of the present disclosure.

The display 204 displays, for example, the information display screen 40 illustrated in FIG. 4 under the control by the controller 101. The information display screen 40 is a screen that displays various information regarding the substrate processing apparatus 1.

The information display screen 40 illustrated in FIG. 4 includes, for example, a title information display area 41, an apparatus information display area 42, and a navigation information display area 43.

The title information display area 41 is a fixed display area. The title information display area 41 is composed of a group of buttons, which are not affected by information on occurring failures as well as a content displayed in the apparatus information display area 42. An event display button 44 for displaying an event item display screen to be described later is disposed in the title information display area 41.

Displays such as, for example, a self-operating apparatus status display, edition of a file such as a recipe or the like, a detailed display of failure information and the like, are switched in the apparatus information display area 42 according to an instruction selected in the navigation information display area 43.

The navigation information display area 43 includes a group of buttons for selecting a type of a screen to be displayed in the apparatus information display area 42.

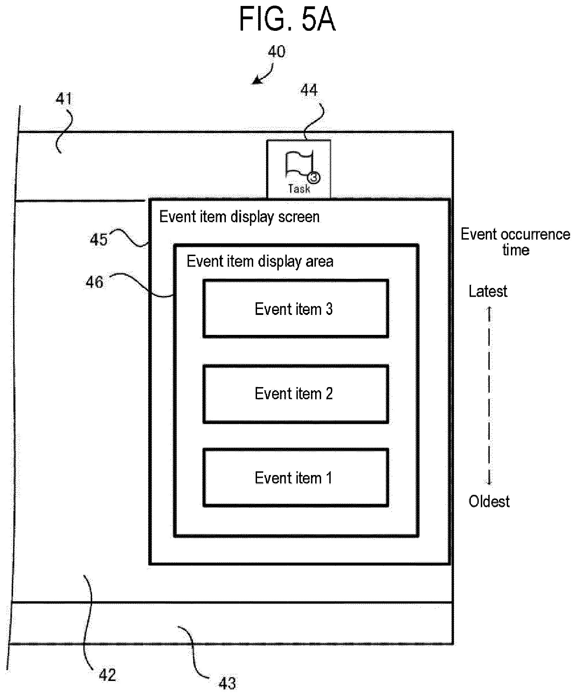

FIG. 5A is a front view illustrating an example of an event item display screen 45 according to the embodiments of the present disclosure.

The display 204 displays, for example, the event item display screen 45 illustrated in FIG. 5A in response to an operation of pressing the event display button 44 or the like. The event display button 44 is disposed in the title information display area 41 and becomes a validity when an event occurs currently but becomes an invalidity when no event occurs currently. As for "validity" and "invalidity" as used herein, for example, the "validity" represents a case where it is possible to press the button and the "invalidity" represents a case where it is impossible to press the button. Further, a case where the button is displayed represents the "validity" and a case where the button is not displayed represents the "invalidity." Further, the title information display area 41 is always displayed and is not hidden in other screens.

As such, by switching the event display button 44 between the validity and the invalidity according to whether or not an event occurred, it is possible to prevent any inadvertent operation when pressing the event display button 44.

The event item display screen 45 illustrated in FIG. 5A is a scree independent from the information display screen 40 illustrated in FIG. 4 as described above. The display 204 displays the event item display screen 45 on the top. The event item display screen 45 is displayed, for example, below the event display button 44 and is always displayed on the top. Therefore, even when the screen in the apparatus information display area 42 is switched, the event item display screen 45 is always displayed on the top. In this case, the apparatus information display area 42 and the event item display screen 45 are displayed in an overlapping manner. In other words, the event item display screen 45 and the information display screen 40 are displayed on different layers (levels), and each screen is displayed independently. Moreover, the event item display screen 45 is disposed on an upper layer, and the information display screen 40 is disposed on a lower layer. Therefore, it is possible to display the event item display screen 45 always on the top rather than the information display screen 40.

As such, since the event item display screen 45 is always displayed on the top even when the screen in the apparatus information display area 42 is switched, it is possible to grasp a currently occurring event although other tasks are performed. Further, it is possible to operate the screen on the lower layer than the event item display screen 45 regardless of the display of the event item display screen 45.

In addition, it is desirable that the display 204 displays the event item display screen 45 immediately below the event display button 44 when the event display button 44 is operated.

By displaying the event item display screen 45 immediately below the event display button 44, a relationship between the event display button 44 and the event item display screen 45 becomes clearer.

The event item display screen 45 includes an event item display area 46 that displays at least one event item indicating a currently occurring event. Specifically, with a notification from the controller 101, the event item display screen 45 arranges and displays event items, which indicate currently occurring events, vertically in the event item display area 46. Since the event item display screen 45 is an independent screen as described above, although other operations on the display 204 (such as switching in the apparatus information display area 42) is performed, the display of the event item display screen 45 is not erased. The displayed event items is formed of event selection buttons, and each event selection button is linked to an event response screen (to be described later) for the corresponding event item. Thus, when touching one event selection button, the display in the apparatus information display area 42 switches to the selected event response screen. In this case, the display of the event item display screen 45 is erased.

As such, by arranging and displaying the event items corresponding respectively to the occurred events among the event items stored in the memory 104, it becomes easy to confirm currently occurring events. That is, this improves visibility for the events.

Further, the event item display area 46 may be set to arrange and display the event items in an new order of event occurrence time at which the event occurs, as illustrated in FIG. 5A. Specifically, the event items displayed in the event item display area 46 are arranged such that the most recently occurred event is placed at the top therein. Thereafter, the event items are arranged in order of the event occurrence time.

By placing the most recent event at the top as described above, it is possible to easily perform a confirmation of the latest event.

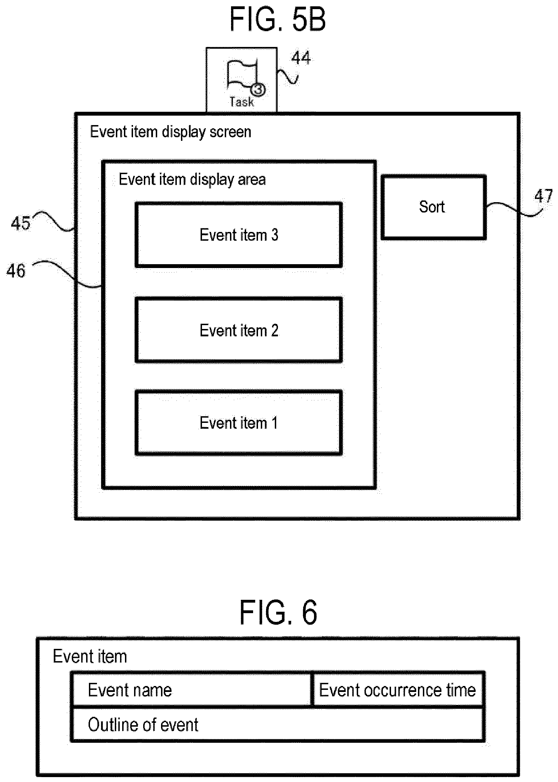

Further, when responding to events in order in which the events occurred, the event items may be arranged in order of the occurrence of events. In other words, the event items may be arranged in order with the oldest event at the top and the currently occurring events below it. Further, the order of arrangement for the event items may be predefined by parameters. Alternatively, as illustrated in FIG. 5B, a sort button 47 for rearrangement may be provided on the event item display screen 45.

FIG. 5B is a front view illustrating another example of the event item display screen 45 according to the embodiments of the present disclosure.

The event item display screen 45 as illustrated in FIG. 5B includes the sort button 47. The sort button 47 for rearrangement may be provided on the event item display screen 45 so as to select an order of arrangement for the event items.

Here, the event item illustrated in FIGS. 5A and 5B includes at least one selected from the group of an event name, an event occurrence time at which the event occurs, and an outline of the event, for example, as illustrated in FIG. 6. In addition, the event occurrence time may include a date and a time when the event occurs. In this case, the event occurrence time is represented as, for example, XXXX-Year, Y-Month, Z-Day, P-Hour, Q-Minute, and R-Second. In addition, in the example of FIG. 6, the event name, the event occurrence time, and the outline of the event are displayed as the event item, but one or more of them may be displayed.

By displaying, as the event item, the event name, the event occurrence time, and the outline of the event as described above, it becomes possible to easily grasp the occurred event.

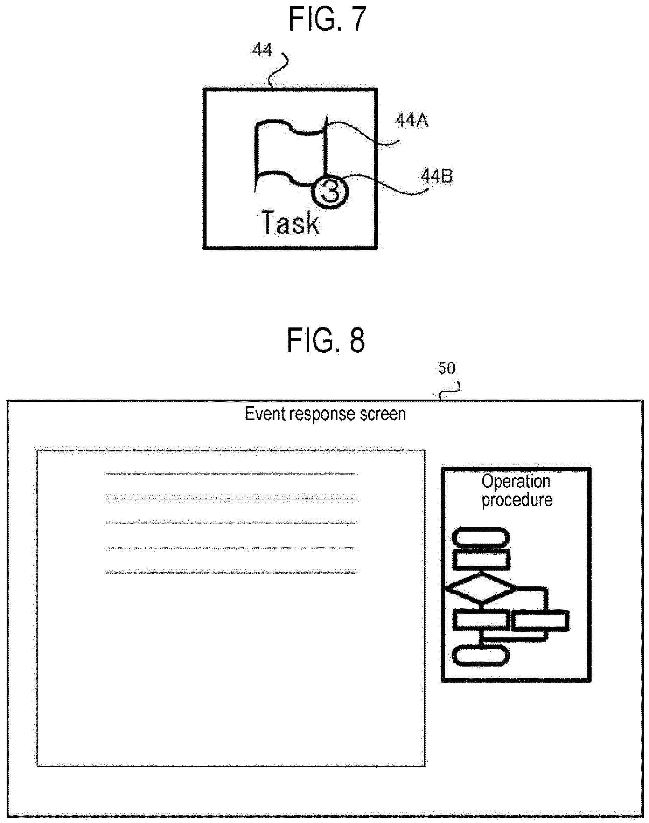

Further, the event display button 44 illustrated in FIGS. 5A and 5B includes a display area that displays, for example, at least one selected from the group of an event occurrence icon 44A indicating occurrence of events and an event occurrence count 44B indicating the number of occurrences for the events, as illustrated in FIG. 7. In addition, in the example of FIG. 7, both the event occurrence icon 44A and the event occurrence count 44B are displayed, but one of them may be displayed.

By displaying the event occurrence icon 44A and the event occurrence count 44B on the event display button 44 as described above, it is possible to confirm whether or not events occurred and the number of occurrences for the events.

A display format of the event occurrence icon 44A may differ between a case where an event occurred and a case where no event occurred. Specifically, the event display button 44 may be set to switch the display of the event occurrence icon 44A between a case where an event occurred and a case where no event occurred. For example, it is conceivable to change a color of the event occurrence icon 44A displayed on the event display button 44 according to whether or not an event occurred. Further, the event occurrence icon 44A may be displayed to be grayed out when no event occurred. Further, when an event occurred, the event occurrence icon 44A may be blinked, or a color of the entire event display button 44 may be changed. Further, the entire event display button 44 may be blinked when an event occurred.

By switching the display of the event occurrence icon 44A when an event occurred as described above, it is possible to confirm the presence or absence of the event occurrence.

Further, the event occurrence count 44B may be displayed when an event occurred and may be set to display the number of occurring events. Specifically, the number of event occurrences displayed as the event occurrence count 44B may be stored in the memory 104. For an even item indicating a currently occurring event among the event items stored in the memory 104, the controller 101 acquires the number of event occurrences and displays it on the display 204.

By displaying the event occurrence count 44B on the event display button 44, it is possible to confirm the number of occurring events without displaying the event item display screen 45.

Further, the event occurrence count 44B may be set to non-display when the occurring event disappeared. Specifically, the event occurrence count 44B on the event display button 44 is set to non-display when no more events occur, that is, when the number of event occurrences is zero. However, the event occurrence count 44B may be displayed as "0."

By setting the event occurrence count 44B to non-display when the occurring event disappeared as described above, it is possible to easily grasp the presence or absence of the event occurrence.

Further, the event item display screen 45 being displayed may be set to non-display in response to the operation of the event display button 44 or switching to another screen. Specifically, the display 204 temporarily maintains the display status (display or non-display) of the event item display screen 45 in the RAM 103. When the event display button 44 is operated, or when switched to another screen, the display status (display or non-display) of the event item display screen 45 is switched.

By temporarily maintaining the display status of the event item display screen 45, it is possible to easily switch between the display and non-display of the event item display screen 45.

Further, the display 204 may disable the operation of the event display button 44 when no event occurred, or may not display the event item display screen 45 even though the event

display button 44 is operated. Specifically, the event display button 44 may be a state not to be pressed (e.g., grayed-out display, etc.) when no event occurred, that is, when the occurring event disappeared. Alternatively, the event item display screen 45 may not be displayed even though the event display button 44 is pressed.

By disabling the operation of the event display button 44 when no event occurred, or preventing the event item display screen 45 from being displayed even when the event display button 44 is operated, it is possible to prevent any inadvertent operation of the event display button 44.

FIG. 8 is a front view illustrating an example of an event response screen 50 according to the embodiments of the present disclosure.

Here, the memory 104 further stores information indicating the event response screen 50 (event response screen information) which performs a response to an event. Addition, deletion, modification, and the like may be possible as the event response screen information stored in the memory 104. For example, when the event item (Event Items 1 to 3) illustrated in FIGS. 5A and 5B as described above is selected, the display 204 displays, for example, the event response screen 50 corresponding to an event of the selected event item, as illustrated in FIG. 8. The event response screen 50 is displayed by switching from the apparatus information display area 42, and the event item display screen 45 is erased.

The event response screen 50 may be acquired through a recording medium such as USB memory, CD, or DVD, or an external device, similar to the event items. For example, when the event item is failure information, the event response screen 50 displays a list of failure information or a detailed failure information screen. When the event item is operation continuation standby, the event response screen 50 displays a system command screen. When the event item is crack detection, the event response screen 50 displays a crack detection recovery screen. When the event item is recipe execution standby, the event response screen 50 displays a recipe execution standby factor confirmation screen. When the event item is update program installation standby, the event response screen 50 displays a program installation screen.

By predefining the event response screen 50 corresponding to each event item, it is possible to immediately transition to the event response screen 50 without searching for the event response screen 50 corresponding to the occurred event.

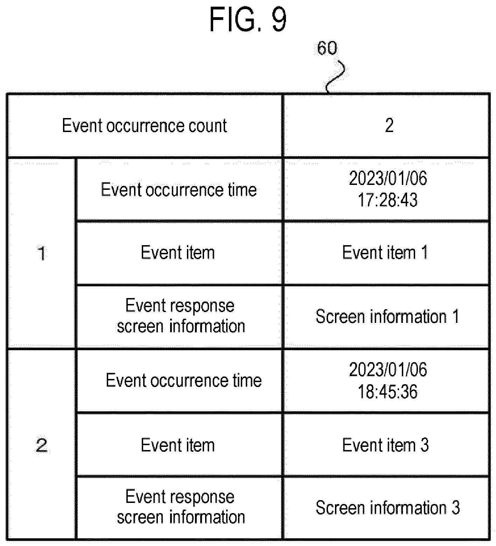

FIG. 9 is a diagram illustrating an example of event item display information 60 according to the present embodiment.

When an event occurs, the occurred event is added to the event item display information 60 illustrated in FIG. 9 in an occurrence order. Among information constituting the event item display information 60, the event items and event response screen information are stored in the memory 104. When events occurred, the event items and event response screen information related to the occurred events are read from the memory 104 to the RAM 103. Then, in the RAM 103, the event item display information 60 is made by associating the event occurrence time related to the occurred event with the number of event occurrences at the current time. The display 204 acquires the number of event occurrences from the event item display information 60, and displays, as the event occurrence count 44B, the acquired number of event occurrences on the event display button 44. Further, the display 204 rearranges the event items acquired from the event item display information 60 based on the event occurrence time and displays the even items on the event item display screen 45.

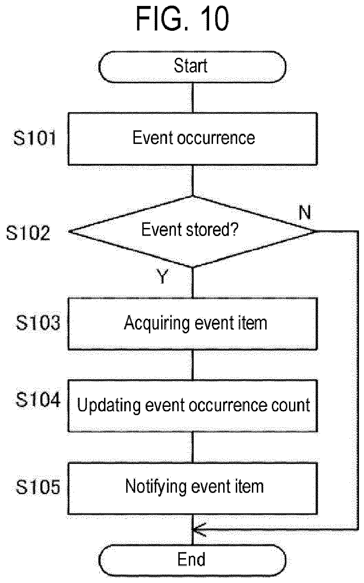

Next, an action of the substrate processing apparatus 1 according to the embodiments of the present disclosure will be described with reference to FIG. 10.

FIG. 10 is a flowchart illustrating an example of a flow of an event occurrence notification process according to the embodiments of the present disclosure.

In step S 101 of FIG. 10, the controller 101 recognizes an occurrence of an event. The recognition of the event occurrence includes, for example, the recognition of a failure, substrate processing, and the like, by a notification from the I/O 105, the recognition of a failure, program update, and the like by a notification from the external communicator 201, and the recognition of program update, and the like by information from the external memory 202.

In step S102, the controller 101 determines whether or not an event item corresponding to the event recognized in step S101 is stored in the memory 104. If it is determined that the event item is stored in the memory 104 (in case of positive determination), the process proceeds to step S 103. If it is determined that the event item is not stored in the memory 104 (in case of negative determination), the event occurrence notification process is terminated.

In step S103, the controller 101 acquires the event item corresponding to the occurred event from the memory 104, and, as an example, stores this event item in the RAM 103 as the event item display information 60 illustrated in FIG. 9 as described above.

In step S104, as an example, the controller 101 updates the number of event occurrences in the event item display information 60 illustrated in FIG. 9 as described above.

In step S105, if the event item corresponding to the occurred event is stored in the memory 104, the controller 101 notifies the display 204 of the event item corresponding to the occurred event, and terminates the event occurrence notification process. For example, the display 204 displays the event item display screen 45 according to the operation of the event display button 44 illustrated in FIG. 5A as described above.

In this way, according to the embodiments of the present disclosure, it is possible to collectively display a plurality of events occurring in a target apparatus by receiving the notification of the event occurrence, so that it is possible to easily conform the events occurring in the target apparatus, facilitate a recovery operation for various events and shorten a down time of the target apparatus.

In the above, the control apparatus and the substrate processing apparatus according to the embodiments have been described by way of example. The embodiments may refer to a program for causing a computer to execute the functions of the control apparatus and the substrate processing apparatus. The embodiments may also refer to a non-transitory recording medium readable by a computer storing such a program.

Moreover, the configurations of the control apparatus and the substrate processing apparatus described in the above embodiments are given by way of example, and may be modified according to situations within the scope without departing from the gist.

Further, the process flow of the program described in the above embodiments are also given by way of example, and steps may be deleted, new steps may be added, or the process sequence may be changed within the scope without departing from the gist.

Further, in the above embodiments, a case where the process related to the embodiments is realized by a software configuration using a computer through the execution of a program has been described, but the embodiments are not limited to this. The embodiments may be realized, for example, by a hardware configuration or a combination of hardware and software configurations.

In the above embodiments, an example of performing a predetermined process on the substrate surface using a batch-type substrate processing apparatus that processes a plurality of substrates at once has been described. The present disclosure is not limited to the above-described aspect, and for example, may be suitably applied to a case where a predetermined process is performed on the substrate surface using a single-wafer type substrate processing apparatus that processes one or several substrates at once. Further, in the above-described aspect, an example of performing a predetermined process on the substrate surface using a substrate processing apparatus with a hot wall type process furnace has been described. The present disclosure is not limited to the above-described aspect and may be suitably applied to a case where a predetermined process is performed on the substrate surface using a substrate processing apparatus with a cold wall type processing furnace as well.

Even when using such a substrate processing apparatus, it is possible to perform each process using the same process procedure and process conditions as in the above-described embodiments, and to achieve the same effects as in the above-described embodiments.

According to the present disclosure in some embodiments, it is possible to facilitate a recovery operation for various events, thereby shortening the downtime of a target apparatus.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the disclosures. The accompanying claims and their equivalents are intended to cover such forms or modifications as would fall within the scope of the disclosures.

## Claims

1. A control apparatus (100) comprising:
a memory (104) that stores an event item indicating at least one event related to a target apparatus (1); and
a controller (101) that is capable of controlling notifying a display (204) of an event item corresponding to an occurred event when the event item corresponding to the occurred event is stored in the memory (104).

2. The control apparatus (100) of Claim 1, wherein the display (204) includes an event item display screen (45), and
wherein the event item display screen (45) includes an event item display area (46) that displays at least one event item that is currently occurring.

3. The control apparatus (100) of Claim 2, wherein the at least one event item is arranged and displayed on the event item display area (46) in order of a new occurrence time that is a time when the event occurred.

4. The control apparatus (100) of Claim 1, wherein the event item includes at least one selected from the group of an event name, an event occurrence time that is a time when the event occurred, and an outline of the event.

5. The control apparatus (100) of Claim 2, wherein the display (204) includes an event display button (44) for display of the event item display screen (45), and
wherein the display (204) displays the event item display screen (45) according to an operation of the event display button (44).

6. The control apparatus (100) of Claim 5, wherein the event display button (44) includes a display area that displays at least one selected from the group of an event occurrence icon indicating occurrence of the event and an event occurrence count indicating the number of occurrences of the event.

7. The control apparatus (100) of Claim 6, wherein a display format of the event occurrence icon differs between a case where the event occurs and a case where no event occurs.

8. The control apparatus (100) of Claim 6, wherein the event occurrence count is displayed when the event occurs and the number of occurring events is displayed.

9. The control apparatus (100) of Claim 1, wherein the memory (104) further stores information indicating an event response screen (50) that performs a response to the event, and
wherein the display (204) displays, when the event item is selected, the event response screen (50) corresponding to the event of the selected event item.

10. The control apparatus (100) of Claim 2, wherein the display (204) further displays an information display screen (40) that displays various information about the target apparatus (1),
wherein the event item display screen (45) is a screen independent from the information display screen (40), and
wherein the display (204) displays the event item display screen (45) on a top.

11. A substrate processing apparatus (1) comprising:
a process container (29) in which processing of a substrate is performed; and
the control apparatus (100) of Claim 1 that is capable of controlling the processing of the substrate based on an event occurrence status.

12. The substrate processing apparatus of Claim 11, wherein the processing of the substrate is performed based on a recipe that defines a process condition of the substrate.

13. The substrate processing apparatus of Claim 12, wherein the event item includes at least one selected from the group of a recovery standby of an alarm occurred in a self-operating apparatus, a condition standby for executing the recipe, a recovery standby due to crack detection in the substrate, a condition standby for continuing the processing of the substrate including the recipe, and an installation standby of an update program.

14. A method of manufacturing a semiconductor device comprising:
storing, in a memory (104), an event item indicating at least one event related to a substrate processing apparatus;
notifying a display (204) of an event item corresponding to an occurred event when the event item corresponding to the occurred event is stored in the memory (104);
displaying the event item notified to the display (204); and
controlling processing of a substrate based on an occurrence status of the event.

15. A program that causes, by a computer, a substrate processing apparatus (1) to perform a process comprising:
storing, in a memory (104), an event item indicating at least one event related to the substrate processing apparatus;
notifying a display (204) of an event item corresponding to an occurred event when the event item corresponding to the occurred event is stored in the memory (104);
displaying the event item notified to the display (204); and
controlling processing of a substrate based on an occurrence status of the event.
